# EUROPÄISCHE PATENTSCHRIFT

(11) **EP 1 329 731 B1**
(45) Veröffentlichungstag und Bekanntmachung des Hinweises auf die Patenterteilung: **11.01.2006**
(21) Anmeldenummer: 03100108.4
(22) Anmeldetag: 20.01.2003
(51) Int. Cl.: G01R 31/00, F02P 17/00, F23Q 23/10, G01R 31/02, G01R 19/00

(54) **Treiberschaltung**
Driver circuit
Circuit d'attaque

(30) Priorität: 22.01.2002 DE 10202289
(43) Veröffentlichungstag der Anmeldung: 23.07.2003
(73) Patentinhaber: SIEMENS AKTIENGESELLSCHAFT, 80333 München (DE)
(72) Erfinder: Bolz, Stephan, 93102, Pfatter (DE)

(56) Entgegenhaltungen:
- EP-A- 0 373 694
- DE-A- 19 630 305
- DE-A- 19 729 904
- DE-A- 19 900 978
- US-A- 4 380 989
- US-A- 4 453 194
- US-A- 5 043 655
- US-B1- 6 278 278

## Beschreibung

Die Erfindung betrifft eine Treiberschaltung zur Ansteuerung eines elektrischen Gerätes über eine Steuerleitung und zur Diagnose des Zustandes der Steuerleitung und/oder des angesteuerten Gerätes gemäß dem Oberbegriff des Anspruchs 1.

In modernen, elektronisch gesteuerten Brennkraftmaschinen erfolgt die Ansteuerung der Zündendstufe bekanntermaßen über Leitungstreiber durch die elektronische Motorsteuerung, wobei die Leitungstreiber verschiedene Anforderungen erfüllen müssen.

So müssen die Leitungstreiber beispielsweise auch dann schnelle Schaltflanken mit einer Schaltdauer von nur 0,5-2 µs erreichen, wenn am Ausgang des Leitungstreibers zur EMV-Unterdrückung ein Kondensator gegen Masse geschaltet ist.

Darüber hinaus müssen die Leitungstreiber eine ausreichende Festigkeit gegenüber einem Masse- bzw. Batteriekurzschluß und für den Fall einer Unterbrechung der Steuerleitung aufweisen.

Schließlich sollen die Leitungstreiber die Diagnose eines Kurzschlusses gegen Masse bzw. Batteriespannung sowie einer Leitungsunterbrechung ermöglichen.

Zur Lösung dieser Diagnoseaufgabe sind Leitungstreiber bekannt, die den Ausgangsstrom messen und mit dem normalen Laststrom vergleichen, um bei einer Abweichung einen Fehler erkennen zu können. So führt ein Massekurzschluß zu einem Stromanstieg über den normalen Laststrom hinaus, während ein Batteriekurzschluß und eine Leitungsunterbrechung zu einer Verringerung des Ausgangsstroms führen.

Problematisch hierbei ist jedoch, dass der Ausgangsstrom des Leitungstreibers während der Einschaltphase zunächst durch den relativ großen Ladestrom für den EMV-Kondensator bestimmt wird, so dass fehlerbedingte Abweichungen des wesentlich geringeren Laststrom nicht erfaßt werden können. So kann der Ladestrom für den EMV-Kondensator beispielsweise 40 mA betragen, während der normale Laststrom lediglich 20 µA beträgt.

Bei den bekannten Leitungstreibern steht die Diagnosefunktion deshalb erst dann zur Verfügung, wenn der EMV-Kondensator weitgehend aufgeladen und der Ladestrom entsprechend abgeklungen ist, so dass fehlerbedingte Abweichungen des Laststroms erfaßt werden können.

Nachteilig an den vorstehend beschriebenen bekannten Leitungstreibern ist also, dass während der Einschaltphase keine dynamische Erkennung einer Leitungsunterbrechung möglich ist.

Weiterhin sind Leitungstreiber bekannt, die während der Einschaltphase einen kleinen Ausgangsstrom von beispielsweise 10 µA auf der Steuerleitung einprägen, wobei der Spannungsanstieg am Ausgang des Leitungstreibers gemessen wird. Bei einer fehlerfreien Steuerleitung lädt nur ein Teil dieses Ausgangsstroms den EMV-Kondensator, während der andere Teil über die Last fließt und dadurch den Spannungsaufbau am EMV-Kondensator verzögert. Bei einer fehlerbedingten Leitungsunterbrechung trägt dagegen der gesamte Ausgangsstrom zum Spannungsaufbau an dem EMV-Kondensator bei, so dass der Spannungsanstieg bei einer Leitungsunterbrechung schneller erfolgt. Die Messung des Spannungsanstiegs während der Einschaltphase ermöglicht deshalb bei diesem Leitungstreibertyp die Erkennung einer Leitungsunterbrechung.

Nachteilig daran ist jedoch, dass eine Leitungsunterbrechung während des normalen Betriebs nach der Einschaltphase auf diese Weise nicht mehr erkannt werden kann, da während des normalen Betriebs kein konstanter Strom eingeprägt werden kann.

Aus US 5 043 655 ist ein Schaltungstester bekannt, der mittels zweier Stromspiegelschaltungen den Strom misst, der aus dem Prüfling oder in den Prüfling fließt, wobei der Messwert mit einem vorgegebenen Referenzwert verglichen wird, um etwaige Fehler des Prüflings zu erkennen.

Weiterhin ist aus DE 199 00 978 A1 eine Schaltungsanordnung zum Ermitteln eines Widerstands eines Zündelements für einen Airbag bekannt, um einen Fehler des Zündelements erkennen zu können. Hierzu wird ein kleiner Prüfstrom in das Zündelement eingespeist und mittels zweier Stromspiegelschaltungen ausgewertet. Die Aktivierung des Zündelements erfolgt hierbei jedoch durch eine separate Insassenschutzmittel-Steueranordnung.

Ferner ist aus DE 197 29 904 A1 eine Schaltungsanordnung zur Überwachung von durch eine Last fließenden Strömen bekannt, die ebenfalls eine Stromspiegelschaltung aufweist. Diese Schaltungsanordnung kann die Last jedoch nur mit High-Pegeln ansteuern.

Weiterhin ist aus DE 196 30 305 A1 eine Schaltungsanordnung zur Messung der Zündspulenprimärspannung einer Zündanlage einer Brennkraftmaschine bekannt. Dabei handelt es sich jedoch nicht um eine Treiberschaltung in dem erfindungsgemäßen Sinne.

Schließlich sind aus HABIGER: "Handbuch Elektromagnetische Verträglichkeit", 2 Aufl. (Verlag Technik GmbH Berlin) allgemein Maßnahmen zur Sicherung der elektromagnetischen Verträglichkeit bekannt.
Der Erfindung liegt deshalb die Aufgabe zugrunde, den eingangs beschriebenen bekannten Leitungstreibertyp dahingehend zu verbessern, dass sowohl während der Einschaltphase als auch im normalen Betrieb die Erkennung einer Leitungsunterbrechung möglich ist.

Diese Aufgabe wird, ausgehend von dem eingangs beschriebenen bekannten Leitungstreiber gemäß dem Oberbegriff des Anspruchs 1, durch die kennzeichnenden Merkmale des Anspruchs 1 gelöst.

Die Erfindung umfaßt die allgemeine technische Lehre, in dem Leitungstreiber ausgangsseitig eine Stromspiegelschaltung anzuordnen, die den Ausgangsstrom der Treiberschaltung in einen Meßstrom umsetzt, der dann zur Erkennung einer Leitungsunterbrechung oder eines Kurzschlusses ausgewertet wird.

Derartige Stromspiegelschaltungen sind für den Fachmann bekannt, so dass auf eine detaillierte Beschreibung sämtlicher Ausführungsformen von Stromspiegelschaltungen verzichtet werden kann und lediglich beispielhaft auf PHILIPPOW, Eugen: Bauelemente und Bausteine der Elektrotechnik, 3. Auflage, Band 3, Seite 669 verwiesen wird.

Der erfindungsgemäße Einsatz einer Stromspiegelschaltung ermöglicht vorteilhaft eine dynamische Erkennung einer Leitungsunterbrechung sowie die Erkennung eines Masse- bzw. Batteriekurzschlusses des ausgangsseitigen Steuerleitung.

Darüber hinaus verträgt die erfindungsgemäße Schaltung vorteilhaft einen Kurzschluß nach Batteriespannung und Masse in allen Schaltzuständen.

Schließlich ist die erfindungsgemäße Schaltung preiswert herstellbar und eignet sich für eine Integration in einem IC.

In der bevorzugten Ausführungsform ist die Stromspiegelschaltung als umgekehrter Stromspiegel ausgebildet und vorzugsweise schaltbar, um neben der Diagnosefunktion auch die Ansteuerung der gewünschten Pegel auf der Steuerleitung zu ermöglichen, wobei der Ausgang für eine spannungsseitige (High-Side) Verwendung vorzugsweise übersteuert ist. Die bewußte Übersteuerung des Ausgangs der Stromspiegelschaltung ermöglicht vorteilhaft die Erfassung eines Laststroms im Bereich von weniger als 20 µA.

Ausgangsseitig ist die Stromspiegelschaltung vorzugsweise mit einer Vergleichereinheit verbunden, die den von der Stromspiegelschaltung aus dem Ausgangsstrom umgesetzten Meßstrom mit einem vorgegebenen Schwellenwert vergleicht und in Abhängigkeit von dem Vergleich ein Diagnosesignal erzeugt. So kann die Vergleichereinheit beispielsweise ein Fehlersignal erzeugen, wenn der aus dem Ausgangsstrom abgeleitete Meßstrom einen vorgegebenen Schwellenwert unterschreitet, was auf einen Leitungsbruch hindeutet.

Die Vergleichereinheit ist eingangsseitig vorzugsweise mit einem Pufferkondensator oder einem RC-Glied verbunden, um während eines Schaltvorgangs Störungen zu verhindern. Die Zeitkonstante des RC-Glieds ist deshalb vorzugsweise kleiner als die Umschaltdauer oder liegt zumindest in der Größenordnung der Umschaltdauer. So kann die Zeitkonstante eines RC-Glieds am Eingang der Vergleichereinheit beispielsweise Werte im Bereich von 5 µs und 20 µs annehmen.

In der bevorzugten Ausführungsform weist die erfindungsgemäße Treiberschaltung zwei Stromspiegelschaltungen auf, wobei die erste Stromspiegelschaltung spannungsseitig mit der Steuerleitung verbunden ist, während die zweite Stromspiegelschaltung masseseitig an die Steuerleitung angeschlossen ist. Zum einen ermöglichen die beiden Stromspiegelschaltungen vorzugsweise die Erzeugung eines High-Pegels und eines Low-Pegels auf der Steuerleitung, um beispielsweise eine Zündendstufe ansteuern zu können. Zum anderen ermöglichen die beiden Stromspiegelschaltungen zusammen die Erkennung einer Leitungsunterbrechung sowie eines Batterie- bzw. Massekurzschlusses.

Die Ansteuerung der beiden Stromspiegelschaltungen erfolgt vorzugsweise gemeinsam durch einen Steuereingang, der beispielsweise mit der elektronischen Motorsteuerung verbunden ist.

In einer Variante der Erfindung erfolgt die Ansteuerung der beiden Stromspiegelschaltungen dagegen getrennt durch jeweils einen Steuereingang. Dies bietet den Vorteil, dass die Treiberschaltung wahlweise als spannungsseitiger (High-Side) oder masseseitiger (Low-Side) Schalter konfiguriert werden kann. Ein weiterer Vorteil einer getrennten Ansteuerung der beiden Stromspiegelschaltungen besteht darin, dass die Treiberschaltung in einen hochohmigen Zustand (Tri-State) gebracht werden kann, indem beide Ausgangstransistoren nicht-leitend gesteuert werden.

Andere vorteilhafte Weiterbildungen sind in den abhängigen Ansprüchen, gekennzeichnet oder werden nachstehend zusammen mit der Beschreibung des bevorzugten Ausführungsbeispiels der Erfindung anhand der Figuren näher erläutert. Es zeigen:
- Figur 1: eine erfindungsgemäße Treiberschaltung als Schaltbild,
- Figur 2: ein Signalverlaufsdiagramm der erfindungsgemäßen Treiberschaltung sowie
- Figur 3: ein alternatives Ausführungsbeispiel der erfindungsgemäßen Treiberschaltung mit einer getrennten Ansteuerung der beiden Stromspiegelschaltungen.

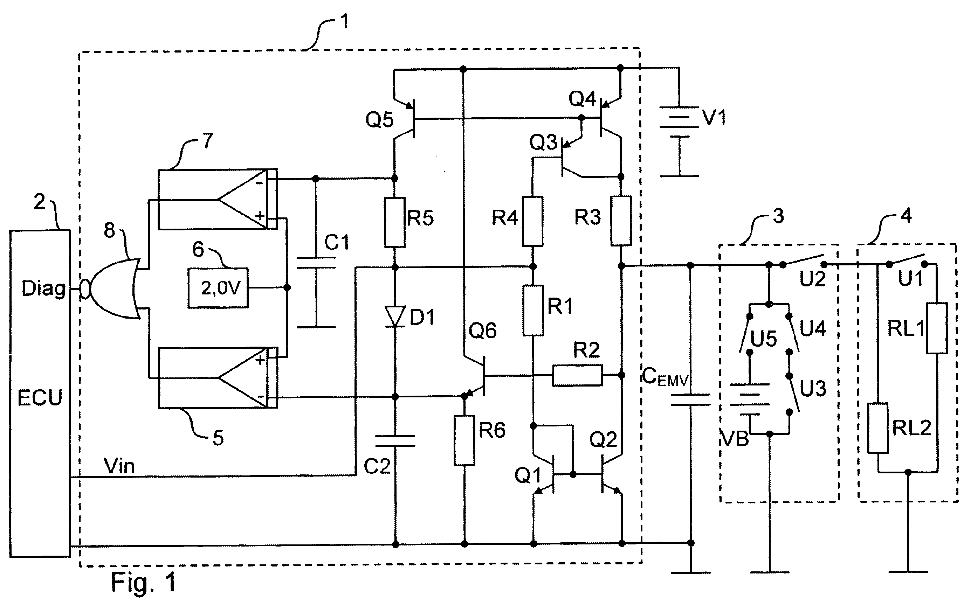

Im folgenden wird zunächst der strukturelle Aufbau der in Figur 1 dargestellten Schaltung beschrieben, um anschließend deren Funktionsweise zu erläutern.

Das in Figur 1 dargestellte Schaltbild zeigt eine erfindungsgemäße Treiberschaltung 1, die über einen Steuereingang Vin von einer elektronischen Motorsteuerung 2 (ECU - Electronic Control Unit) angesteuert wird, wobei die Treiberschaltung 1 der Motorsteuerung 2 auch ein Diagnosesignal DIAG zurückliefert, wie noch eingehend erläutert wird.

Ausgangsseitig ist die Treiberschaltung 1 über eine schematisch dargestellte Steuerleitung 3 mit einer ebenfalls nur schematisch dargestellten Zündendstufe 4 verbunden.

Die Zündendstufe 4 ist hierbei als Ersatzschaltbild aus einem Schalter U1 und zwei Lastwiderständen RL1=2kΩ und RL2=200kΩ dargestellt. Der Schalter U1 ermöglicht hierbei eine Variation des Lastwiderstands der Zündendstufe 4 entsprechend dem jeweiligen Betriebszustand der Zündendstufe.

Auch die Steuerleitung 3 ist hierbei als Ersatzschaltbild aus einer Batterie VB und mehreren Schaltern U2, U3, U4 und U5 dargestellt. Ein Öffnen des Schalters U2 entspricht hierbei einer Leitungsunterbrechung, während das Schließen des Schalters U5 einen Batteriekurzschluß nachbildet. Schließlich entspricht das Schließen der Schalter U3 und U4 einem Massekurzschluß der Steuerleitung 3.

Zur Ansteuerung der Steuerleitung 3 mit einem High-Pegel oder einem Low-Pegel sowie zu Diagnosezwecken weist die Treiberschaltung zwei Stromspiegelschaltungen auf.

Die erste Stromspiegelschaltung ist spannungsseitig mit der Steuerleitung 3 verbunden und besteht aus drei Transistoren Q3, Q4 und Q5.

Die zweite Stromspiegelschaltung ist dagegen masseseitig an die Steuerleitung 3 angeschlossen und besteht aus den Transistoren Q1, Q2 und Q6.

Die Ansteuerung der beiden Stromspiegelschaltungen erfolgt durch die elektronische Motorsteuerung 2 über den gemeinsamen Steuereingang Vin, der über einen Widerstand R1=430Ω mit dem Kollektor des Transistors Q1 und über einen Widerstand R4=100kΩ mit der Basis des Transistors Q3 verbunden ist.

Die Steuerleitung 3 ist über den Transistor Q4 und einen Widerstand R3=100Ω mit einer Versorgungsspannung V1=5V und über den Transistor Q2 mit Masse verbunden. Auf der Steuerleitung 3 liegt also ein High-Pegel, wenn der Transistor Q4 durchschaltet, wohingegen die Steuerleitung 3 einen Low-Pegel annimmt, wenn der Transistor Q2 durchschaltet.

Die Ansteuerung des masseseitigen Transistors Q2 erfolgt durch den Transistor Q1, wobei die beiden Transistoren Q1 und Q2 einen Stromspiegel bilden. Die Basis des Transistors Q2 ist deshalb sowohl mit der Basis des Transistors Q1 als auch mit dem Kollektor des Transistors Q1 verbunden, während die Emitter der beiden Transistoren Q1 und Q2 gemeinsam an Masse angeschlossen sind. Der Strom durch den Transistor Q1 ist deshalb gleich dem Strom durch den Transistor Q2.

In ähnlicher Weise sind auch die Kollektoren der beiden Transistoren Q4 und Q5 der spannungsseitigen Stromspiegelschaltung miteinander verbunden. Zusätzlich weist die spannungsseitige Stromspiegelschaltung den Transistor Q3 auf, dessen Emitter mit dem Verbindungspunkt zwischen dem Widerstand R3 und dem Transistor Q4 verbunden ist, während der Kollektor des Transistors Q3 mit der Basis des Transistors Q4 verbunden ist.

Zu Diagnosezwecken weist die Treiberschaltung 1 weiterhin einen Transistor Q6 auf, dessen Kollektor mit der Versorgungsspannung V1 verbunden ist, während der Emitter des Transistors Q6 über einen Widerstand R6=100kΩ mit Masse verbunden ist. Die Basis des Transistors Q6 ist dagegen über einen Widerstand R2=10kΩ mit der Steuerleitung 3 verbunden. Dies bedeutet, dass der Emitter des Transistors Q6 bis maximal zur Versorgungsspannung dem Spannungspegel auf der Steuerleitung 3 folgt.

Zur Auswertung des Spannungsverlaufs ist der Emitter des Transistors Q6 mit dem invertierenden Eingang eines Komparators 5 verbunden, wobei der nicht-invertierende Eingang des Komparators 5 mit einem Referenzspannungselement 6 verbunden ist, das eine Referenzspannung U_{TH}=2,0V liefert. Weiterhin ist der invertierende Eingang des Komparators 5 über einen Kondensator C2=0,1nF mit Masse verbunden, wobei der Kondensator C2 mit dem Widerstand R6 ein RC-Glied bildet, dessen Zeitkonstante sicherstellt, dass bei Schaltvorgängen keine Störungen ("Glitches") auftreten.

Ferner weist die Treiberschaltung einen Komparator 7 auf, dessen invertierender Eingang mit dem Emitter des Transistors Q5 verbunden ist, während das Referenzspannungselement 6 an den nicht-invertierenden Eingang des Komparators 7 angeschlossen. Darüber hinaus ist auch an dem invertierenden Eingang des Komparators 7 ein Pufferkondensator C1=0,1nF gegen Masse geschaltet, wobei der Pufferkondensator C1 mit dem Widerstand R5 ein RC-Glied bildet.

Ausgangsseitig sind die beiden Komparatoren 5, 7 mit einem NOR-Gatter 8 verbunden, dass den Diagnoseausgang DIAG ansteuert.

Im folgenden wird zunächst die normale Ansteuerung der Steuerleitung 3 beschrieben, wenn weder eine Leitungsunterbrechung noch ein Batterie- oder Massekurzschluß vorliegt.

In diesem Fall gibt die Motorsteuerung 2 an dem Steuereingang Vin der Treiberschaltung 1 die zu übertragenden Daten in digitaler Form vor, indem der Steuereingang Vin entweder auf einen Low-Pegel V_{Low}=0 V oder auf einen High-Pegel V_{High}=5 V gelegt wird.

Bei einem High-Pegel an dem Steuereingang Vin fließt über den Widerstand R1 und den als Diode geschalteten Transistor Q1 ein Strom von ungefähr 10 mA. Da die beiden Transistoren Q1 und Q2 eine Stromspiegelschaltung bilden, fließt dann auch über den Transistor Q2 ein Strom von ungefähr 10 mA. Dies bedeutet, dass der Spannungsabfall über dem Transistor Q2 gleich der Sättigungsspannung von ungefähr 0,2 V ist, so dass an der Steuerleitung 3 in diesem Fall ein Low-Pegel ausgegeben wird. In diesem Zustand ist der Transistor Q3 stromlos geschaltet, so dass auch der Transistor Q4 sperrt.

Wenn der Steuereingang Vin der Treiberschaltung 1 dann mit einem Low-Pegel angesteuert wird, so fließt kein Strom mehr durch den Widerstand R1, wodurch die Transistoren Q1 und Q2 sperren. Bei einem Low-Pegel an dem Steuereingang Vin wird allerdings der Transistor Q3 leitend geschaltet, so dass auch der Transistor Q4 durchschaltet, der dann als Diode wirkt. Die Versorgungsspannung V1 treibt dann einen Strom über den Transistor Q4 und den Widerstand R3, der den EMV-Kondensator C_{EMV} auflädt und an der Zündendstufe 4 einen High-Pegel von ungefähr 4 V erzeugt.

Ein High-Pegel an dem Steuereingang Vin führt also zu einem Low-Pegel auf der Steuerleitung 3, wohingegen ein Low-Pegel an dem Steuereingang Vin einen High-Pegel auf der Steuerleitung 3 verursacht.

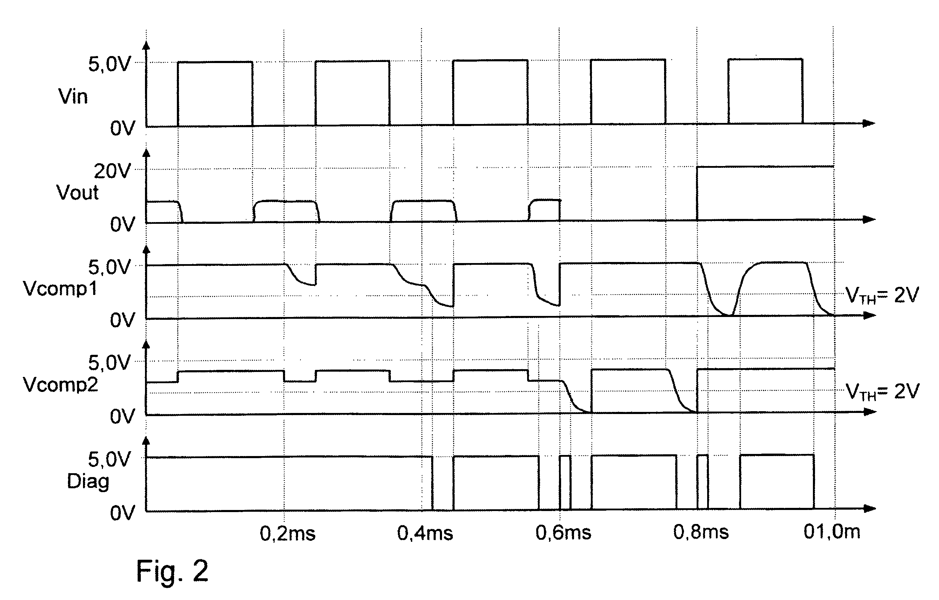

Im folgenden wird nun die Diagnosefunktion der erfindungsgemäßen Treiberschaltung 1 beschrieben, wobei zunächst ein fehlerfreier Betrieb angenommen wird, in dem weder ein Masse- bzw. Batteriekurzschluß noch eine Leitungsunterbrechung vorliegt. Dieser Betriebszustand ist in dem in Figur 2 dargestellten Signaldiagramm zwischen t=0 ms und t=0,4 ms wiedergegeben, wobei der Schalter U1 in der Zeitspanne von t=0 ms bis t=0,2 ms geöffnet ist und die Zündendstufe 4 entsprechend wenig Strom zieht, während der Schalter U1 in der Zeitspanne von t=0,2 ms bis t=0,4 ms geschlossen ist und die Zündendstufe entsprechend mehr Strom über die Steuerleitung 3 zieht.

Der Schalter U1 soll in dem dargestellten Ersatzschaltbild die Funktion der Schaltung bzw. die Diagnose innerhalb der Grenzwerte des Lastwiderstands von 2 kΩ bis 200 kΩ veranschaulichen. In der realen Applikation ist der Schalter U1 dagegen nicht vorhanden, da eine Simulation des variierenden Lastwiderstands dann nicht erforderlich ist.

In diesem fehlerfreien Betrieb folgt der Emitter des Transistors Q6 durch die Ansteuerung über den Widerstand R2 dem Spitzenwert der Ausgangsspannung auf der Steuerleitung 3 bis maximal zu der Versorgungsspannung V1. Bei einem High-Pegel auf der Steuerleitung 3 führt dies zu einer Spannung am Emitter des Transistors Q6 von mehr als 3 V und damit zu einem High-Pegel an dem invertierenden Eingang des Komparators 5.

Falls die Steuerleitung 3 dann von einem High-Pegel auf einen Low-Pegel wechselt, so sinkt die Spannung an dem Emitter des Transistors Q6 mit einer Zeitkonstante τ₁=1/(R6·C6)=10µs. Der Steuereingang Vin hat dann jedoch bereits wieder einen High-Pegel, der über die Diode D1 auch an dem Emitter des Transistors Q6 anliegt. Die Pufferung durch das aus dem Widerstand R6 und dem Kondensator C2 bestehende RC-Glied stellt also sicher, dass die Spannung beim Umschalten nicht nennenswert absinkt und deshalb im fehlerfreien Betrieb stets ein High-Pegel an dem Emitter des Transistors Q6 anliegt. Dieser normale High-Pegel an dem Emitter des Transistors Q6 wird von dem Komparator 5 mit dem vorgegebenen Schwellenwert U_{TH}=2 V verglichen, so dass am Ausgang des Komparators 5 normalerweise immer ein Low-Pegel erscheint.

Bei einem fehlerfreien Betrieb fließt über den Transistor Q5 der gleiche Strom wie über den Transistor Q4, da die beiden Transistoren Q4 und Q5 eine Stromspiegelschaltung bilden. Bei einem High-Pegel des Steuereingangs Vin nimmt die Steuerleitung 3 einen Low-Pegel an, wobei die beiden Transistoren Q5 und Q4 stromlos sind. Der High-Pegel an dem Steuereingang Vin lädt dann den Kondensator C1 über den Widerstand R5 auf, so dass an dem invertierenden Eingang des Komparators 7 ein High-Pegel anliegt, der mit dem vorgegebenen Schwellenwert U_{TH}=2 V vergleichen wird. Bei einem High-Pegel an dem Steuereingang Vin und einem Low-Pegel auf der Steuerleitung erscheint also im fehlerfreien Betrieb ein Low-Pegel am Ausgang des Komparators 7.

Falls der Steuereingang Vin dann auf einen Low-Pegel wechselt, so wird der Transistor Q4 über den Transistor Q3 leitend geschaltet, so dass die Versorgungsspannung V1 einen Strom über den Transistor Q4 und den Widerstand R3 durch den EMV-Kondensator C_{EMV} und die Zündendstufe 4 treibt. Dieser Strom wird anfangs durch den Ladestrom durch den EMV-Kondensator C_{EMV} dominiert und beträgt zunächst rund 45 mA. Mit dem Abklingen des Ladevorgangs des EMV-Kondensators C_{EMV} wird der Ausgangsstrom jedoch zunehmend durch den Strom durch die Zündendstufe 4 bestimmt. Hierbei fließt durch den Transistor 05 ein gleich großer Strom, da die beiden Transistoren Q4 und Q5 eine Stromspiegelschaltung bilden. Solange der EMV-Kondensator C_{EMV} aufgeladen wird, liegt am Kollektor des Transistors Q5 und damit auch an dem invertierenden Eingang des Komparators 7 sicher ein High-Pegel, da der Spannungsabfall über dem Transistor Q5 dann gleich der relativ geringen Sättigungsspannung ist. Nach dem Abklingen des Ladevorgangs für den EMV-Kondensator C_{EMV} wird der Strom durch den Transistor Q4 und damit auch der Strom durch den Transistor Q5 allein durch den Laststrom durch die Zündendstufe 4 bestimmt. Je nach dem Schaltzustand des Schalters U1 beträgt dieser Laststrom 2mA oder 20 µA. In beiden Fällen reicht dieser Laststrom jedoch aus, um an dem invertierenden Eingang des Komparators 7 einen High-Pegel von mehr als 2 v aufrecht zu erhalten. Im fehlerfreien Betrieb erscheint also auch am Ausgang des Komparators 7 stets ein Low-Pegel, so dass die Diagnoseleitung DIAG aufgrund des zwischengeschalteten NOR-Gatters 8 im fehlerfreien Betrieb einen High-Pegel ausgibt.

Im folgenden wird nun das Diagnoseverhalten der Treiberschaltung 1 für den Fall eines Massekurzschlusses beschrieben, was einem Durchschalten der beiden Schalter U3 und U4 entspricht.

Dieser Fehlerfall ist in dem in Figur 2 dargestellten Signaldiagramm zwischen t=0,6 ms und t=0,8 ms wiedergegeben.

In diesem Fall liegt auf der Steuerleitung 3 unabhängig von der Ansteuerung durch den Steuereingang Vin stets ein Low-Pegel an, der den Transistor Q6 über den Widerstand R2 ansteuert, so dass das Potential an dem invertierenden Eingang des Komparators 5 ebenfalls auf einen Wert von weniger als 2 V abfällt. Bei einem Massekurzschluß der Steuerleitung 3 erscheint also am Ausgang des Komparators 5 ein High-Pegel, der über das NOR-Gatter 8 als Low-Pegel auf der Diagnoseleitung DIAG ausgegeben wird.

Nachfolgend wird nun das Diagnoseverhalten bei einem Batteriekurzschluß der Steuerleitung 3 beschrieben, was einem Schließen des Schalters U5 entspricht, während die Schalter U3 und U4 geöffnet sind. Dieser Fehlerfall ist in dem in Figur 2 dargestellten Signaldiagramm zwischen t=0,8 ms und t=1,0 ms wiedergegeben.

Bei diesem Fehlerfall kann die Versorgungsspannung V1 auch dann keinen Strom mehr über den Transistor Q4 treiben, wenn an dem Steuereingang Vin ein Low-Pegel anliegt, da die Batteriespannung VB dagegen wirkt. Entsprechend fließt dann auch kein Strom mehr über den Transistor Q5, so dass an dem invertierenden Eingang des Komparators 7 nur dann ein High-Pegel anliegt, wenn der Steuereingang Vin über den Widerstand R5 einen High-Pegel vorgibt. Falls der Steuereingang Vin dann aber auf einen Low-Pegel wechselt, so sinkt die Spannung an dem Eingang des Komparators mit der Zeitkonstanten τ₁ unter den Schwellenwert von U_{TH}=2V ab, so dass dann am Ausgang des Komparators 7 ein High-Pegel erscheint, der über das NOR-Gatter 8 als Low-Pegel auf der Diagnoseleitung ausgegeben wird.

Schließlich wird nun der Fehlerfall einer Leitungsunterbrechung beschrieben, was einem Öffnen des Schalters U2 entspricht. Dieser Fehlerfall ist in dem in Figur 2 dargestellten Signaldiagramm zwischen t=0,4 ms und t=0,6 ms wiedergegeben.

In diesem Fehlerfall sinkt der Strom durch den Transistor Q4 nach dem Abklingen des Ladevorgangs des EMV-Kondensators C_{EMV} bis auf Null, da die Zündendstufe 4 aufgrund der Leitungsunterbrechung der Steuerleitung keinen Strom ziehen kann. Dementsprechend sinkt dann auch der Strom durch den Transistor Q5, da die beiden Transistoren Q4 und Q5 eine Stromspiegelschaltung bilden. Bei einem High-Pegel auf dem Steuereingang Vin wirkt sich dies nicht auf den invertierenden Eingang des Komparators 7 aus, da der High-Pegel auf dem Steuereingang Vin über den Widerstand R5 auch auf den invertierenden Eingang des Komparators 7 wirkt. Wenn der Steuereingang Vin dann aber auf einen Low-Pegel wechselt, so entlädt sich der Pufferkondensator C1 über den Widerstand R5, wodurch das Potential an dem invertierenden Eingang des Komparators 7 bis unter den Schwellenwert U_{TH}=2 V absinkt. Bei einer Leitungsunterbrechung auf der Steuerleitung 3 erscheint also am Ausgang des Komparators 7 ein High-Pegel, der aufgrund des nachgeschalteten NOR-Gatters 8 als Low-Pegel auf der Diagnoseleitung ausgegeben wird.

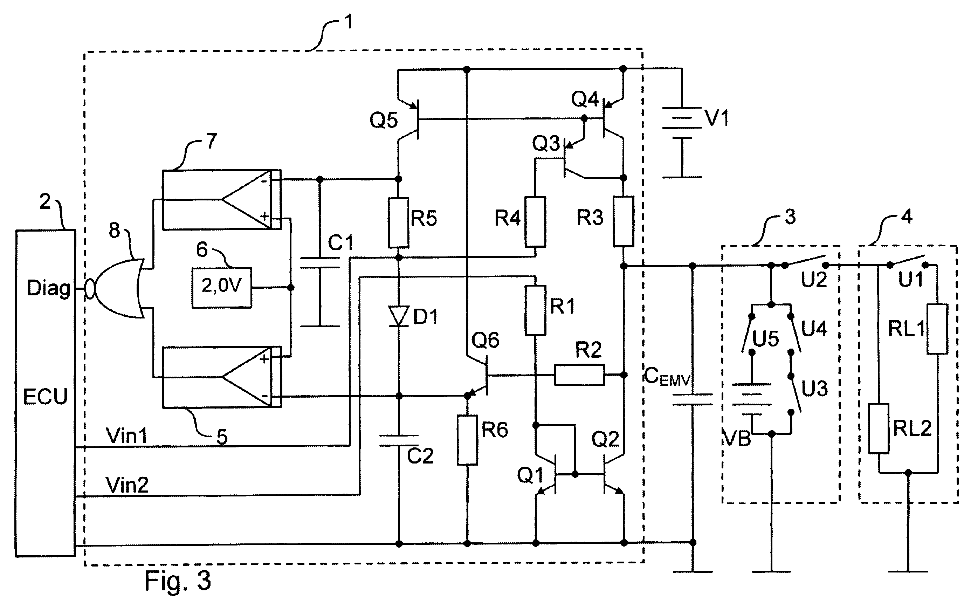

Das in Figur 3 dargestellte Ausführungsbeispiel einer erfindungsgemäßen Treiberschaltung 1 stimmt weitgehend mit dem vorstehend beschriebenen und in Figur 1 dargestellten Ausführungsbeispiel überein, so dass im folgenden dieselben Bezugszeichen verwendet werden und zur Vermeidung von Wiederholungen auf die vorstehende Beschreibung verwiesen wird.

Die Besonderheit dieses Ausführungsbeispiels besteht darin, dass die Treiberschaltung 1 zwei Steuereingänge Vin1 und Vin2 aufweist, die jeweils eine der beiden Stromspiegelschaltungen ansteuern. So steuert der Steuereingang Vin1 über den Widerstand R4 die spannungsseitige Stromspiegelschaltung an, die aus den Transistoren Q3, Q4 und Q5 besteht, während der Steuereingang Vin2 über den Widerstand R1 die masseseitige Stromspiegelschaltung ansteuert, die aus den Transistoren Q1 und Q2 besteht.

Diese getrennte Ansteuerung der beiden Stromspiegelschaltung bietet den Vorteil, dass die Treiberschaltung 1 wahlweise als spannungsseitiger (High-Side) Schalter oder als masseseitiger (Low-Side) Schalter konfiguriert werden kann.

Darüber hinaus besteht auf diese Weise auch die Möglichkeit, den Steuerausgang in einen hochohmigen Zustand (Tri-State) zu versetzen, indem die beiden Transistoren Q4 und Q2 nicht-leitend geschaltet werden.

## Patentansprüche

1. Treiberschaltung (1)
a) zur Ansteuerung einer Zündendstufe (4) einer Brennkraftmaschine über eine Steuerleitung (3) und
b) zur Diagnose des Zustands der Steuerleitung (3) und/oder der Zündendstufe (4), mit
c) einer mit der Steuerleitung (3) verbundenen Messschaltung (Q1-Q6, R1-R6) zur Messung des über die Steuerleitung (3) fließenden elektrischen Ausgangsstroms und
d) einer mit der Messschaltung verbundenen Auswertungseinheit (5-8), die in Abhängigkeit von dem gemessenen Ausgangsstrom ein Diagnosesignal (DIAG) erzeugt,
e) wobei die Messschaltung zwei Stromspiegelschaltungen (Q1, Q2; Q4, Q5) aufweist und
f) wobei die erste Stromspiegelschaltung (Q4, Q5) spannungsseitig mit der Steuerleitung (3) verbunden ist,
g) während die zweite Stromspiegelschaltung (Q1, Q2) masseseitig mit der Steuerleitung (3) verbunden ist,
**dadurch gekennzeichnet**,
h) dass die Auswertungseinheit (5-8) zwei Vergleichereinheiten (5, 7) aufweist,
i) die jeweils den Ausgangsstrom oder ein von dem Ausgangsstrom abgeleitets Signal mit einem vorgegebenen Schwellenwert vergleichen und das Diagnosesignal (DIAG) in Abhängigkeit von dem Vergleich erzeugen.

2. Treiberschaltung (1) nach Anspruch 1,
**dadurch gekennzeichnet,**
**dass** die Steuerleitung (3) über einen ersten Kondensator (C_{EMV}) mit Masse verbunden ist, um die elektromagnetische Verträglichkeit zu verbessern.

3. Treiberschaltung (1) nach mindestens einem der vorhergehenden Ansprüche,
**dadurch gekennzeichnet,**
**dass** die Auswertungseinheit (5-8) eingangsseitig über einen Pufferkondensator (C1, C2) mit Masse verbunden ist.

4. Treiberschaltung (1) nach Anspruch 3,
**dadurch gekennzeichnet,**
**dass** die Auswertungseinheit (5-8) eingangsseitig über ein RC-Glied (R5, C1; R6, C2) mit Masse verbunden ist.

5. Treiberschaltung (1) nach Anspruch 4,
**dadurch gekennzeichnet,**
**dass** die Zeitkonstante des RC-Glieds (R5, C1; R6, C2) kleiner ist als die Umschaltdauer oder in der Größenordnung der Umschaltdauer liegt.

6. Treiberschaltung (1) nach Anspruch 5,
**dadurch gekennzeichnet,**
**dass** die Zeitkonstante des RC-Glieds (R5, C1; R6, C2) zwischen 5 µs und 20 µs liegt.

7. Treiberschaltung (1) nach mindestens einem der vorhergehenden Ansprüche,
**dadurch gekennzeichnet,**
**dass** die beiden Vergleichereinheiten (5, 7) ausgangsseitig mit einer Logikschaltung (8) verbunden sind, die das Diagnosesignal (DIAG) in Abhängigkeit von dem Ausgangssignal der beiden Vergleichereinheiten (5, 7) erzeugt.

8. Treiberschaltung (1) nach Anspruch 7,
**dadurch gekennzeichnet,**
**dass** die Logikschaltung (8) ein ODER-Glied aufweist.

9. Treiberschaltung (1) nach mindestens einem der Ansprüche,
**dadurch gekennzeichnet,**
**dass** die Stromspiegelschaltungen (Q1, Q2; Q4, Q5) eingangseitig gemeinsam mit einem einzigen Steuereingang (Vin) verbunden sind.

10. Treiberschaltung (1) nach mindestens einem der Ansprüche 1 bis 8,
**dadurch gekennzeichnet,**
**dass** die beiden Stromspiegelschaltungen (Q1, Q2; Q4, Q5) eingangsseitig getrennt mit jeweils einem Steuereingang (Vin1, Vin2) verbunden sind.

## Claims

1. Driver circuit (1)
a) for actuating an ignition output stage (4) in an internal combustion engine via a control line (3) and
b) for diagnosing the state of the control line (3) and/or of the ignition output stage (4), having
c) a test circuit (Q1-Q6, R1-R6), connected to the control line (3), for measuring the electrical output current flowing via the control line (3), and
d) an evaluation unit (5-8), connected to the test circuit, for generating a diagnostic signal (DIAG) on the basis of the measured output current,
e) the test circuit having two current mirror circuits (Q1, Q2; Q4, Q5), and
f) the first current mirror circuit (Q4, Q5) being connected to the voltage side of the control line (3),
g) while the second current mirror circuit (Q1, Q2) is connected to the earth side of the control line (3),
**characterized**
h) in that the evaluation unit (5-8) has two comparator units (5, 7)
i) which respectively compare the output current or a signal derived from the output current with a prescribed threshold value and generate the diagnostic signal (DIAG) on the basis of the comparison.

2. Driver circuit (1) according to Claim 1,
**characterized**
**in that** the control line (3) is earthed via a first capacitor (C_{EMC}) in order to improve the electromagnetic compatibility.

3. Driver circuit (1) according to one of the preceding claims,
**characterized**
**in that** the input side of the evaluation unit (5-8) is earthed via a buffer capacitor (C1, C2).

4. Driver circuit (1) according to Claim 3,
**characterized**
**in that** the input side of the evaluation unit (5-8) is earthed via an RC element (R5, C1; R6, C2).

5. Driver circuit (1) according to Claim 4,
**characterized**
**in that** the time constant of the RC element (R5, C1; R6, C2) is smaller than the switching time or is in the order of magnitude of the switching time.

6. Driver circuit (1) according to Claim 5,
**characterized**
**in that** the time constant of the RC element (R5, C1; R6, C2) is between 5 µs and 20 µs.

7. Driver circuit (1) according to at least one of the preceding claims,
**characterized**
**in that** the outputs of the two comparator units (5, 7) are connected to a logic circuit (8) which generates the diagnostic signal (DIAG) on the basis of the output signal from the two comparator units (5, 7).

8. Driver circuit (1) according to Claim 7,
**characterized**
**in that** the logic circuit (8) has an OR gate.

9. Driver circuit (1) according to at least one of the preceding claims,
**characterized**
**in that** the inputs of the current mirror circuits (Q1, Q2; Q4, Q5) are connected to a single control input (Vin) together.

10. Driver circuit (1) according to at least one of claims 1 to 8,
**characterized**
**in that** the inputs of the two current mirror circuits (Q1, Q2; Q4, Q5) are connected to a respective control input (Vin1, Vin2) separately.

## Revendications

1. Circuit d'attaque (1)
a) destiné à l'activation d'un étage final d'allumage (4) d'un moteur à combustion interne par l'intermédiaire d'une ligne de commande (3) et
b) destiné au diagnostic de l'état de la ligne de commande (3) et/ou de l'étage final d'allumage (4), comprenant
c) un circuit de mesure (Q1-Q6, R1-R6) relié à la ligne de commande (3) et destiné à la mesure du courant de sortie électrique qui circule dans la ligne de commande (3) et
d) une unité d'analyse (5-8) reliée au circuit de mesure, qui produit un signal de diagnostic (DIAG) en fonction du courant de sortie mesuré,
e) dans lequel le circuit de mesure comprend deux circuits à miroir de courant (Q1, Q2 ; Q4, Q5) et
f) dans lequel le premier circuit à miroir de courant (Q4, Q5) est relié côté tension à la ligne de commande (3),
g) tandis que le second circuit à miroir de courant (Q1, Q2) est relié à la ligne de commande (3) côté masse,
**caractérisé en ce que**
h) l'unité d'analyse (5-8) présente deux unités comparateurs (5, 7),
i) qui comparent à chaque fois le courant de sortie ou un signal dérivé du courant de sortie à une valeur de seuil prédéterminée et produisent un signal de diagnostic (DIAG) en fonction de la comparaison.

2. Circuit d'attaque (1) selon la revendication 1,
**caractérisé en ce que**
la ligne de commande (3) est reliée à la masse à travers un premier condensateur (C_{EMV}) pour améliorer la compatibilité électromagnétique.

3. Circuit d'attaque (1) selon au moins une des revendications précédentes,
**caractérisé en ce que**
l'unité d'analyse (5-8) est reliée côté entrée à la masse à travers un condensateur tampon (C1, C2).

4. Circuit d'attaque (1) selon la revendication 3,
**caractérisé en ce que**
l'unité d'analyse (5-8) est reliée côté entrée à la masse à travers un élément RC (R5, C1 ; R6, C2).

5. Circuit d'attaque (1) selon la revendication 4,
**caractérisé en ce que**
la constante de temps de l'élément RC (R5, C1 ; R6, C2) est plus petite que la durée de commutation ou est de l'ordre de grandeur de la durée de commutation.

6. Circuit d'attaque (1) selon la revendication 5,
**caractérisé en ce que**
la constante de temps de l'élément RC (R5, C1 ; R6, C2) est comprise entre 5 µs et 20 µs.

7. Circuit d'attaque (1) selon au moins une des revendications précédentes,
**caractérisé en ce que**
les deux unités comparateurs (5, 7) sont reliées côté sortie à un circuit logique (8) qui produit le signal de diagnostic (DIAG) en fonction du signal de sortie des deux unités comparateurs (5, 7).

8. Circuit d'attaque (1) selon la revendication 7,
**caractérisé en ce que**
le circuit logique (8) présente un élément OU.

9. Circuit d'attaque (1) selon au moins une des revendications,
**caractérisé en ce que**
les circuits à miroir de courant (Q1, Q2 ; Q4, Q5) sont reliés en commun, côté entrée, à une unique entrée de commande (Vin).

10. Circuit d'attaque (1) selon au moins une des revendications 1 à 8,
**caractérisé en ce que**
les deux circuits à miroir de courant (Q1, Q2 ; Q4, Q5) sont reliés séparément, côté entrée, chacun à une entrée de commande (Vin1, Vin2) .
